# EUROPÄISCHE PATENTSCHRIFT

(11) **EP 0 400 367 B1**
(45) Veröffentlichungstag und Bekanntmachung des Hinweises auf die Patenterteilung: **03.08.1994**
(21) Anmeldenummer: 90108780.9
(22) Anmeldetag: 10.05.1990
(51) Int. Cl.: H01L 31/048, H01L 31/052, E04F 13/08, G02B 5/32

(54) **Aussenwandelement für Gebäude**
Exterior wall element for buildings
Elément de paroi extérieure pour édifices

(30) Priorität: 30.05.1989 DE 3917503
(43) Veröffentlichungstag der Anmeldung: 05.12.1990
(73) Patentinhaber: Müller, Helmut Frank Ottomar, Prof. Dr.-Ing., D-50933 Köln (DE); Gutjahr, Joerg, Prof. Dr., D-51588 Nümbrecht (DE)
(72) Erfinder: Müller, Helmut Frank Ottomar, Prof. Dr.-Ing., D-50933 Köln (DE); Gutjahr, Joerg, Prof. Dr., D-51588 Nümbrecht (DE)
(74) Vertreter: Selting, Günther, Dipl.-Ing.

(56) Entgegenhaltungen:
- EP-A- 0 034 211
- DE-A- 3 140 974
- US-A- 4 204 881
- LASER FOCUS, Band 17, Nr. 12, Dezember 1981, Seiten 38,40,41, Newton, MA, US; "Holographic optics concentrate solar rays" und "Holographic windows"

## Beschreibung

Die Erfindung betrifft ein Außenwandelement für Gebäude nach dem Oberbegriff des Patentanspruchs 1.

Aus DE-OS 27 52 178 sind Außenwandelemente mit zwei parallelen Scheiben bekannt, zwischen denen Solarzellen zur Energiegewinnung angeordnet sind. Solche Außenwandelemente sind jedoch nicht lichtdurchlässig. Aus DE-OS 31 25 622 sind Außenwandelemente bekannt, die zwischen zwei parallelen Glasscheiben eine fluoreszierende Glasscheibe aufweisen. Am Rand der fluoreszierenden Glasscheibe sind Fotoelemente zur Energiegewinnung angeordnet. Dieses Außenwandelement ermöglicht einen Lichtdurchgang, jedoch ist die Energieausbeute der Fotoelemente gering und außerdem kann die in das Gebäude einfallende Strahlungsenergie nicht reguliert werden.

DE-OS 30 05 914 beschreibt einen Sonnenkollektor, der eine Scheibe mit zahlreichen nebeneinander angeordneten holografischen Elementen aufweist. Im Abstand hinter den holografischen Elementen sind Gruppen von Solarzellen angeordnet, die für unterschiedliche Spektralbereiche empfindlich sind. Die holografischen Elemente fokussieren die Strahlung der verschiedenen Wellenlängen auf die jeweils zugehörigen Solarzellen. Dieser Sonnenkollektor ist nicht als Außenwandelement für Gebäude bestimmt und er ist nicht imstande Licht oder Wärmestrahlung durchzulassen, so daß er keine Beleuchtungsfunktion erfüllen kann.

Laser Focus Band 17, Nr 12, Dezember 1981 Seiten 38, 40, 41 beschreibt ein holografisches Element welches als Fenster eines Gebäudes verwendet werden kann. Das Licht das von oben einfällt wird auf ein Strahlungsempfangselement gebündelt, während das horizontal einfallende Licht durchgelassen wird.

Der Erfindung liegt die Aufgabe zugrunde, ein Außenwandelement für Gebäude zu schaffen, das eine wirksame Ausnutzung der Sonnenstrahlung zur Beleuchtung und zur Beheizung des Gebäudes oder zu Energiegewinnungszwecken ermöglicht.

Die Lösung dieser Aufgabe erfolgt erfindungsgemäß mit den im Patentanspruch 1 angegebenen Merkmalen.

Bei dem erfindungsgemäßen Außenwandelement ist eine Scheibe mit mindestens einem strahlungssammelnden holografischen Element vorgesehen. Ein Strahlungsempfangselement befindet sich hinter dem holografischen Element im wesentlichen in dessen Fokalebene. Die Scheibe und das Strahlungsempfangselement sind relativ zueinander bewegbar, so daß die einfallende Strahlung wahlweise auf das Strahlungsempfangselement gebündelt oder ganz oder teilweise an diesem vorbeigeleitet wird. Dadurch besteht die Möglichkeit, wahlweise entweder Strahlung in das Gebäude hinein durchzulassen oder die einfallende Strahlung ganz oder teilweise zur Energiegewinnung zu nutzen. Die Verstellung des Strahlungsempfangselements in Bezug auf die Scheibe erfolgt entweder manuell durch den Benutzer oder in Abhängigkeit von einer thermostatischen bzw. lichttechnischen Regelung des Gebäudes.

Die Strahlungsempfangselemente können entweder fotoelektrische Umsetzer, flüssigkeitsdurchströmte Wärmekollektoren, die Einlässe von Lichtwellenleitern, Wärmeabsorptionsflächen oder Reflektoren sein. Bei dem Außenwandelement wird die von der Sonne her einfallende Strahlung auf die Strahlungsempfangselemente konzentriert, während diffus einfallende Strahlung durchgelassen wird. Das Außenwandelement ermöglicht sowohl eine Energiegewinnung als auch eine Raumbeleuchtung und eine Raumbeheizung mit Sonnenenergie.

Vorzugsweise sind an der Scheibe zahlreiche holografische Elemente vorgesehen, wobei hinter jedem dieser holografischen Elemente ein Strahlungsempfangselement angeordnet ist. Die Strahlungsempfangselemente nehmen nur einen Teil der Gesamtfläche der Scheibe ein. Sie können an einer zweiten Scheibe angeordnet sein, die hinter der ersten Scheibe in ihrer Gesamtheit verschiebbar ist. Es besteht aber auch die Möglichkeit, die Strahlungsempfangselemente einzeln vorzusehen und sie untereinander zu verbinden, wobei zwischen benachbarten Strahlungsempfangselementen freie Durchlässe oder Löcher vorgesehen sind.

Die zwischen den Strahlungsempfangselementen befindlichen Bereiche können zu einem Teil durchlässig und zu einem anderen Teil reflektierend gestaltet sein, um das optische Verhalten des Außenwandelements durch den Benutzer derart verändern zu können, daß Energie, die nicht zur Raumbeleuchtung oder Raumheizung und auch nicht für die elektrische Energiegewinnung benötigt wird, zu reflektieren und damit das Gebäude kühl zu halten.

Die optischen Elemente auf der äußeren Scheibe sind holografische Linsen. Die Hologramme sind in einer Schicht der äußeren Scheibe als Beugungsgitter vorhanden. Hologramme haben die Eigenschaft, einfallendes Licht richtungsselektiv abzulenken. Sie werden erzeugt, indem zwei kohärente Laserstrahlen, die aus unterschiedlichen Richtungen auftreffen, einander überlagert werden und durch Interferenz ein Strichmuster der Lichtdichteverteilung in der fotografischen Beschichtung der Scheibe bilden. Die auftreffenden Laserstrahlen sind nicht durch einen Bildinhalt moduliert. Wenn ein auf der äußeren Scheibe angebrachtes Hologramm aus derselben Richtung beleuchtet wird, aus der einer der hologrammerzeugenden Strahlen eingefallen ist, und wenn die Beleuchtung mit derselben Wellenlänge wie derjenigen des hologrammerzeugenden Strahls erfolgt, wird der andere hologrammerzeugende Strahl rekonstruiert. Erfolgt die Beleuchtung mit einer Strahlung anderer Wellenlänge, so erfolgt ebenfalls eine Rekonstruktion des zweiten Strahls, jedoch ändert sich der Beugungswinkel. Wenn ein derartiges Hologramm mit polychromatischem Licht, z.B. weißem Tageslicht, beleuchtet wird, bewirkt es eine Spektralzerlegung. Diese Spektralzerlegung kann dazu ausgenutzt werden, nur die für die Energiegewinnung geeigneten Wellenlängen auf die Lichtempfangselemente zu leiten und die anderen Wellenlängen, z.B. diejenigen des sichtbaren Lichts, durchzulassen. Auf diese Weise gelingt es, die Wärmestrahlung vom Inneren des Gebäudes fernzuhalten und gleichzeitig zur Energiegewinnung zu benutzen, während sichtbares Licht zu Beleuchtungszwecken durchgelassen wird.

Die Scheibe und die Strahlungsempfangselemente sind relativ zueinander bewegbar, um Wärmeenergie wahlweise dem Gebäude zuführen zu können oder sie fernzuhalten. Zum Zuführen von Wärmeenergie zum Gebäude werden die von den Strahlungsempfangselementen freigelassenen strahlungsdurchlässigen Bereiche in die Brennbereiche der holografischen Elemente der Scheibe gebracht. Soll dagegen Strahlungswärme vom Gebäude ferngehalten werden, werden entweder Reflexionsflächen oder Strahlungsempfangselemente in die Brennbereiche der holografischen Elemente gebracht.

Eine weitere Bewegung der Scheibe und der Strahlungsempfangselemente kann zum Zwecke der Nachführung entsprechend dem Sonnenstand vorgesehen sein, um die holografischen Elemente stets so auf die Sonne auszurichten, daß die gewünschten Bereiche der dahinter angeordneten Struktur mit den Brennbereichen der äußeren Scheibe zusammenfallen.

Die äußere Scheibe muß nicht die nach außen raumabschließende Außenhaut des Außenwandelementes sein. Vor der äußeren Scheibe kann noch eine Schutzscheibe angeordnet sein. In diesem Fall ist die äußere Scheibe zwischen der Schutzscheibe und den Strahlungsempfangselementen bewegbar angeordnet. Zweckmäßigerweise ist auch an der Innenseite des Außenwandelementes eine Schutzscheibe angeordnet, die die raumseitige Begrenzung des Außenwandelementes bildet.

Im folgenden werden unter Bezugnahme auf die Zeichnungen Ausführungsbeispiele der Erfindung näher erläutert.

Es zeigen:
- Fig. 1: eine schematische Frontansicht des in optische Bereiche aufgeteilten Außenwandelementes,
- Fig. 2: einen Vertikalschnitt entlang der Linie II-II von Fig. 1,
- Fig. 3: einen Schnitt entlang der Linie III-III von Fig. 2,
- Fig. 4: einen Horizontalschnitt entlang der Linie IV-IV von Fig. 1,
- Fig. 5: in gleicher Darstellung wie Fig. 3 ein weiteres Ausführungsbeispiel,
- Fig. 6: einen Vertikalschnitt durch eine andere Ausführungsform der Erfindung,
- Fig. 7: einen Schnitt entlang der Linie VII-VII von Fig. 6,
- Fig. 8: ein weiteres Ausführungsbeispiel der Erfindung,
- Fig. 9: eine Seitenansicht eines weiteren Ausführungsbeispiels der Erfindung,
- Fig. 10: eine Ansicht von Fig. 9 aus Richtung des Pfeiles X, und
- Fig. 11: eine Ansicht von Fig. 10 aus Richtung des Pfeiles XI.

Das Außenwandelement weist zwei parallele Scheiben aus Glas auf, nämlich die äußere Scheibe 10 und die innere Scheibe 11. Diese Scheiben sind in einen Rahmen 12 eingesetzt und sie sind in einem Abstand von etwa 20 mm angeordnet. Der Bereich zwischen den beiden Scheiben 10 und 11 ist leer. Dieser Bereich ist gegen die Umgebung staubdicht abgeschlossen. Er kann wahlweise luftgefüllt oder auch evakuiert sein.

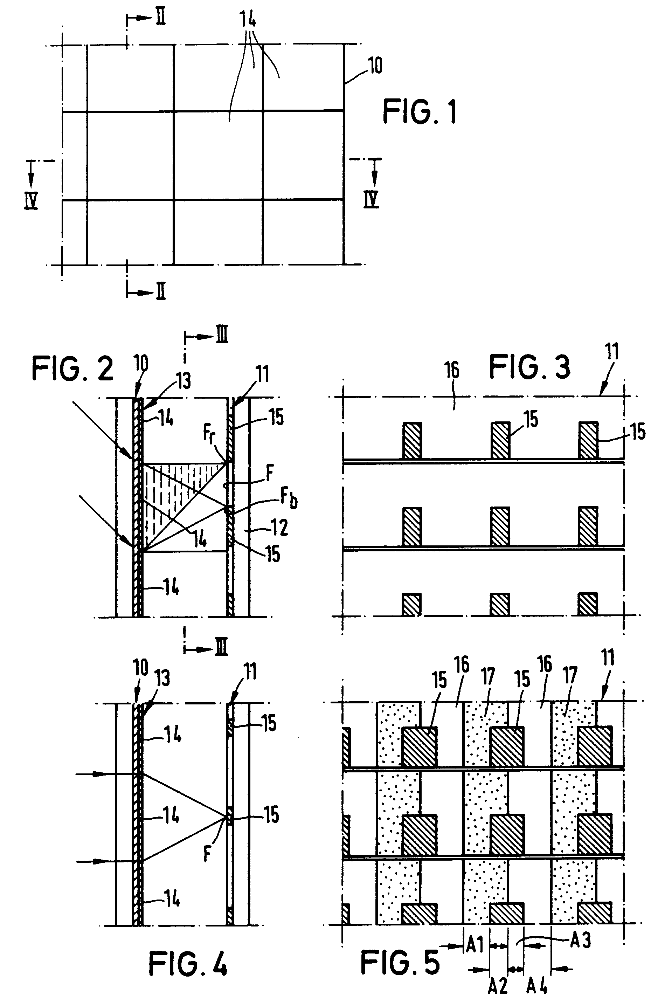

Die äußere Scheibe 10 trägt an ihrer Innenseite eine Beschichtung 13 mit zahlreichen Hologrammen. Diese Beschichtung 13 kann aus einer fotoempfindlich Emulsion oder einem Fotopolymeren bestehen. In der Schicht 13 sind schachbrettartig zahlreiche strahlungssammelnde optische Elemente 14 als Hologramme erzeugt. Diese optischen Elemente sind holografische Linsen, deren Brennebene so gewählt ist, daß sie mit der Innenseite der dem Gehäuseinneren zugewandten inneren Scheibe 11 zusammenfällt. Die optischen Elemente 14 bewirken eine linienförmige Fokussierung der einfallenden Strahlung entlang einer vertikalen Linie, wobei sich entlang dieser vertikalen Linie eine Spektralverteilung ergibt. In Fig. 2 ist diese Spektralverteilung angedeutet. Die schräg einfallende Strahlung wird entlang der vertikalen Fokallinie F fokussiert, wobei das langwellige Licht in vertikaler Richtung stärker abgelenkt wird als das kurzwellige. Der Fokus des roten Lichts ist mit Fᵣ bezeichnet und der Fokus des blauen Lichts mit F_{b}. Wie aus den Fign. 2 und 4 ersichtlich ist, erfolgt eine Spektralzerlegung nur in vertikaler Richtung entlang der Fokallinie F.

Hinter jedem der strahlungssammelnden holografischen Elemente 14 der äußeren Scheibe 10 ist an der inneren Scheibe 11 ein Strahlungsempfangselement 15 angeordnet. Dieses Strahlungsempfangselement 15 ist beispielsweise ein fotoelektrischer Umsetzer, z.B. eine Solarzelle, oder der Einlaß einer Lichtwellenleiteranordnung aus einem oder mehreren Lichtleitern. Die Strahlungsempfangselemente sind entlang der Fokallinie F angeordnet, erstrecken sich in vertikaler Richtung aber nur über denjenigen Bereich, für den sie sensibel sind. Bei dem vorliegenden Ausführungsbeispiel ist dies der untere Bereich derjenigen Fläche der inneren Scheibe 11, die dem Feld 14 entspricht. Die geht aus Fig. 3 hervor, wo erkennbar ist, daß die Strahlungsempfangselemente 15 sich jeweils nur über einen Teil der Höhe eines Feldes 14 erstrecken. Da in horizontaler Richtung eine starke Fokussierung erfolgt, sind die horizontalen Erstreckungen der Strahlungsempfangselemente 15 sehr gering. Die übrigen Bereiche 16, die von den Strahlungsempfangselementen 15 frei sind, sind lichtdurchlässig. Die Strahlungsempfangselemente 15, die bei dem vorliegenden Ausführungsbeispiel Solarzellen sind, sind mit dünnen Drähten, die in die Scheibe 11 eingelassen sind, verbunden, um die von den Solarzellen erzeugten Spannungen abzuführen. Wie aus Fig. 3 hervorgeht, nehmen die Strahlungsempfangselemente 15 nur einen geringen Teil der Fläche der Scheibe 11 ein. Sie erstrecken sich maximal über 10 % der Fläche, sofern sie für einen fokussierten Strahlungsempfang ausgelegt sind.

Um dem Lauf der Sonne folgen zu können, ist eine Translationsbewegung der beiden Scheiben 10 und 11 relativ zueinander vorgesehen, und zwar sowohl in vertikaler Richtung als auch in horizontaler Richtung. Hierbei ist beispielsweise die äußere Scheibe 10 in der Weise bewegt, daß die Strahlungsempfangselemente 15 stets ein Maximum an Strahlungsenergie empfangen.

Es besteht auch die Möglichkeit, die Scheiben 10 und 11 so zu verschieben, daß die Fokallinie F nicht mit den Strahlungsempfangselementen 15 zusammenfällt, so daß die gesamte Sonnenstrahlung durch die Scheibe 11 hindurch dem Gebäudeinneren zugeführt wird. Der Benutzer kann somit entscheiden, ob die Sonnenenergie zur Beleuchtung oder zur Erwärmung des Gebäudes genutzt werden soll oder zur Stromgewinnung.

Das in Fig. 5 dargestellte Ausführungsbeispiel entspricht dem ersten Ausführungsbeispiel, mit dem Unterschied, daß die innere Scheibe 11 außer den transparenten Bereichen 16 noch reflektierende Bereiche 17 aufweist. Die transparenten Bereiche 16 und die reflektierenden Bereiche 17 sind von gleicher Größe und sie sind symmetrisch um das Strahlungsempfangselement 15 angeordnet. Dadurch entstehen die in Fig. 5 angegebenen Bereiche A1,A2,A3 und A4. In dem Bereich A1 ist das Flächenelement über seine gesamte Höhe reflektierend. Von dem Bereich A2 wird ein Teil vom Strahlungsempfangselement und ein anderer Teil von der reflektierenden Fläche 17 eingenommen. Vom Bereich A3 wird ein Teil vom Strahlungsempfangselement 15 und ein anderer Teil von der transparenten Fläche 16 eingenommen. Der Bereich A4 besteht über seine gesamte Höhe aus transparenter Fläche 16. Durch horizontales Verschieben der Scheibe 10 kann der Benutzer bestimmen, in welchen der Bereiche A1 bis A4 die Fokallinie F fällt. Auf diese Weise kann das physikalische Verhalten des Außenwandelementes entsprechend den Wünschen des Benutzers geändert werden. Im Bereich A1 ist das Außenwandelement reflektierend, im Bereich A2 erfolgt Reflexion und Stromerzeugung, im Bereich A3 Lichtdurchlaß und Stromerzeugung und im Bereich A4 ausschließlich Lichtdurchlaß. Anstelle der Solarzellen können auch Lichtwellenleiter eingesetzt werden. Die reflektierende Schicht der Bereiche 17 wird als dielektrische Beschichtung aus Metalloxid aufgebracht. Auch die Leiterbahnen für den Anschluß der Strahlungsempfangselemente können als Leiterschichten auf der Scheibe 11 vorgesehen sein.

Wenn eine exakte Nachführung entsprechend dem Sonnenstand vorhanden ist, brauchen die Strahlungsempfangselemente 15 (und ggf. die reflektierenden Flächen 17) nur sehr klein zu sein, da durch die holografischen Linsen eine starke Fokussierung der Strahlung erfolgt. Dadurch entstehen große durchlässige Flächen 16, die diffus einfallendes Licht durchlassen.

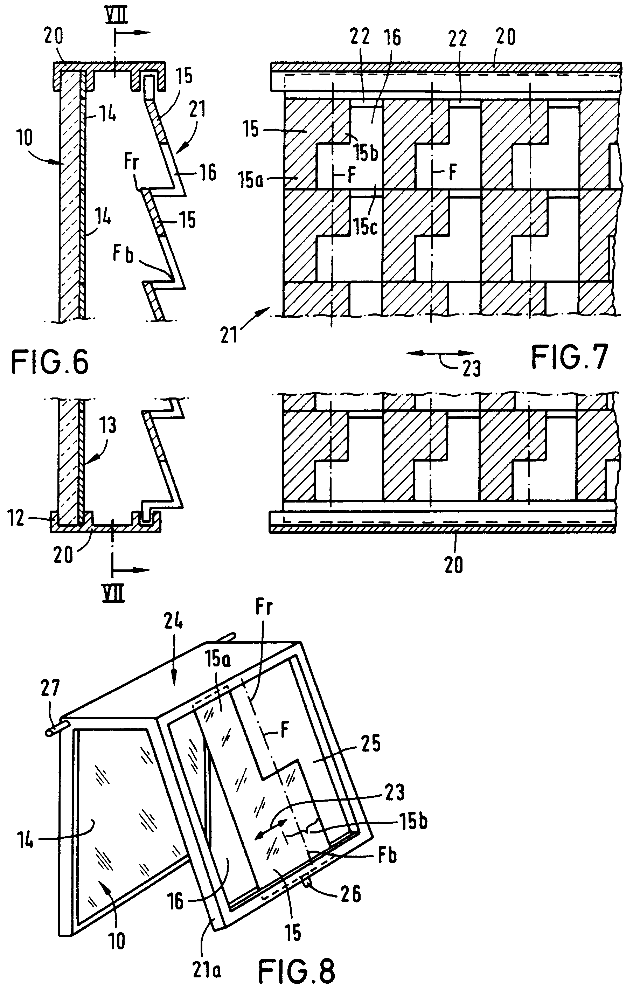

Bei dem Ausführungsbeispiel der Fign. 6 und 7 ist die Scheibe 10 mit der Beschichtung 13, in der die holografischen Elemente 14 vorgesehen sind, in einem Rahmen 20 fest angebracht. In dem Rahmen 20 ist eine Tragstruktur 21 mit den Strahlungsempfangselementen 15 horizontal verschiebbar im Rahmen 20 angeordnet. Die Tragstruktur 21 ist im wesentlichen sägezahnförmig ausgebildet, weil bei holografischer Fokussierung die Fokallinie F nicht parallel zu dem Hologramm verläuft, sondern der Fokus Fᵣ für das langwellige (rote) Licht einen geringeren Abstand von dem Hologramm hat als der Fokus F_{b} für das kurzwellige (blaue) Licht. Durch die schräge Anordnung der Empfangsfelder kann erreicht werden, daß jedes Empfangsfeld dem Verlauf der Fokallinie folgt. Die in den Empfangsfeldern angeordneten Strahlungsempfangselemente 15 verlaufen somit - im vertikalen Querschnitt betrachtet - unter einem spitzen Winkel zu der Scheibe 10.

In einem vertikalen Streifen 15a, der etwa einem Drittel der Breite eines Empfangsfeldes oder eines Feldes 14 entspricht, erstreckt sich jedes Strahlungsempfangselement 15 über die gesamte Höhe des Empfangsfeldes. In einem anschließenden Streifen 15b, der nur einem Teil der Höhe des Empfangsfeldes entspricht, erstreckt sich das Strahlungsempfangselement nur über den oberen Teil der Höhe des Empfangsfeldes und in einem weiteren Streifen 15c nimmt der freie Bereich 16 die gesamte Höhe des Empfangsfeldes ein. Sämtliche Strahlungsempfangselemente 15 sind in vertikaler Richtung untereinander verbunden und in horizontaler Richtung sind die Bereiche zwischen zwei benachbarten Strahlungsempfangselementen 15 durch Verbindungselemente 22 verbunden. Sämtliche Strahlungsempfangselemente 15 bilden somit eine einheitliche Tragstruktur 21, die in ihrer Gesamtheit unter Beibehaltung des Abstandes zur Scheibe 10 relativ zur Scheibe parallel verschiebbar ist, wie durch den Doppelpfeil 23 in Fig. 7 angedeutet wird.

Durch Verschieben der Tragstruktur 21 relativ zu der Scheibe 10 kann erreicht werden, daß entweder die Streifen 15a oder die Streifen 15b oder die über die gesamte Höhe durchlässigen Streifen 15c mit den Fokallinien F zusammenfallen. Wenn die Streifen 15a auf die Fokallinien F eingestellt werden, wird die gesamte einfallende und fokussierte Energie auf die Strahlungsempfangselemente geleitet, so daß keine Strahlung in das Gebäude gelangt. Werden die Streifen 15b auf die Fokallinien F eingestellt, wird bei dem vorliegenden Beispiel nur die langwellige Strahlung in Energie umgesetzt bzw. vom Gebäude ferngehalten, während die kurzwellige Strahlung durchgelassen wird. Wird dagegen die vollständige Höhe des freien Bereichs 16 auf die Fokallinie F eingestellt, dann wird die gesamte Strahlung in der Gebäude hinein durchgelassen.

Durch geeignete Ausbildung des freien Bereichs 16 kann erreicht werden, daß selektiv nur Strahlung eines bestimmten Wellenlängenbereichs durchgelassen wird. Auf diese Weise kann die Farbe des Lichts, das in das Gebäude eingelassen wird, ausgewählt werden.

Die freien Bereiche 16 können aus lichtdurchlässigem Glas bestehen oder auch einfach Löcher sein.

Es ist auch möglich, den Übergang zwischen den Streifen 15a,15b und 15c nicht stufenförmig sondern durch eine schräge Begrenzungslinie des Strahlungsempfangselementes 15 kontinuierlich zu gestalten. Auf diese Weise können der Anteil und die Menge des durchgelassenen Lichts kontinuierlich verändert werden.

Schließlich besteht auch die Möglichkeit, die Scheibe 10 und die Tragstruktur 21 relativ zueinander in vertikaler Richtung zu bewegen, um unterschiedliche Färbungen des in das Gebäude fallende Lichts zu erhalten. Während bei horizontaler Relativbewegung die Menge des durchgelassenen Lichts verändert und somit ein Dimmeffekt erzielt wird, wird vertikaler Relativbewegung die Lichtfarbe verändert.

Bei dem Ausführungsbeispiel von Fig. 8 ist ein Rahmen 24 vorgesehen, der die vertikale Scheibe 10 mit einem einzigen holografischen Element 14 trägt. Der Rahmen 24 weist hinter der Scheibe 10 eine Tragstruktur 21a auf, in der das Strahlungsempfangselement 15 horizontal verschiebbar angeordnet ist (Doppelpfeil 23). Das Strahlungsempfangselement 15 befindet sich in dem Fenster 25 der Tragstruktur 21a und kann derart bewegt werden, daß entweder sein Bereich 15a oder sein Bereich 15b mit der Fokallinie F des holografischen Elements 14 zusammenfällt oder daß das Strahlungsempfangselement 15 überhaupt nicht mit der Fokallinie F zusammenfällt. Die horizontale Bewegung des Strahlungsempfangselements 15 erfolgt durch einen (nicht dargestellten) Verstellmechanismus, der an einem Zapfen 26 des Strahlungsempfangselementes angreift.

Zur Nachführung in Bezug auf die Sonnenhöhe ist der Rahmen 24 um eine horizontale Achse 27 herum schwenkbar.

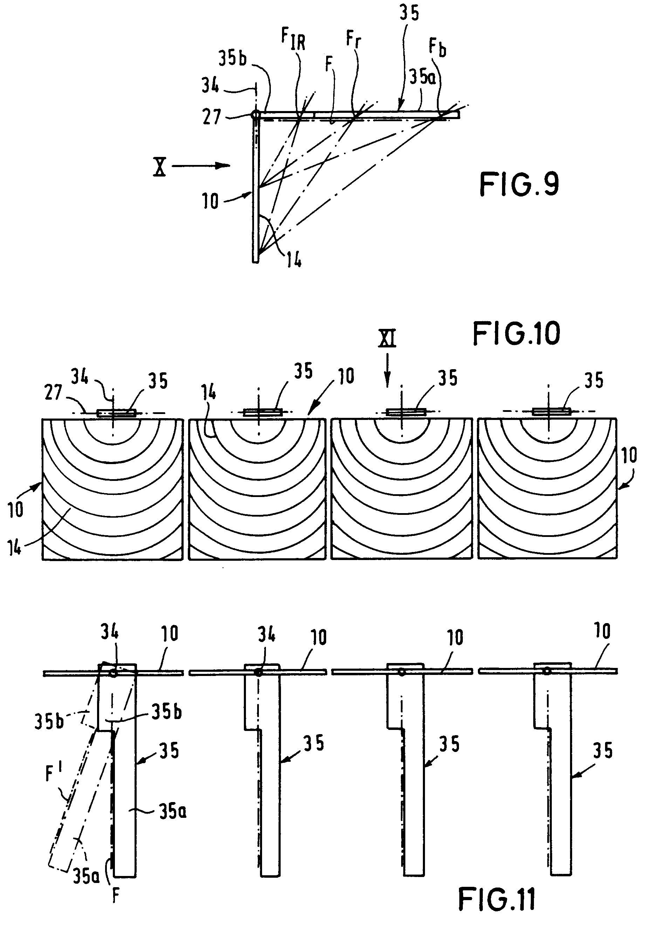

In den Fign. 9 bis 11 ist ein Ausführungsbeispiel dargestellt, bei dem mehrere Scheiben 10 mit jeweils einem Hologramm 14 parallel zueinander angeordnet sind. Jede der Scheiben 10 ist um eine vertikale Mittelachse 34 herum schwenkbar angebracht, so daß eine Nachführung der Scheiben 10 entsprechend dem Höhenwinkel der Sonne möglich ist. Von dem oberen Ende jeder Scheibe 10 steht eine Blende 35 in Form eines Streifens oder Balkens ab. Die Hologramme 14 sind so ausgebildet, daß die Fokallinie F im wesentlichen rechtwinklig zur Scheibe 10 verläuft, wie aus Fig. 9 hervorgeht. Die Blende 35 ist entlang der Fokallinie F angeordnet. Diese Blende ist strahlungsundurchlässig und vorzugsweise strahlungsabsorbierend, so daß sie die von der Sonne einfallende und vom Hologramm 14 gebündelte Strahlung entlang der Fokallinie F aufnehmen kann.

Die Blende 35 kann um die vertikale Achse 34 herum relativ zur Scheibe 10 geschwenkt werden, so wie dies in Fig. 11 gestrichelt dargestellt ist. In diesem Fall wird die einfallende Strahlung entlang der Fokallinie F nicht abgeschattet und in das Gebäude hineingelassen. Wenn sich der Sonnenstand im Azimut ändert, dreht sich die Fokallinie F um die Achse 34, um z.B. die Stellung F′ einzunehmen. Die Blende 35 kann dem Azimutwinkel derart nachgeführt werden, daß die Lage der Blende in bezug auf die Fokallinie gleichbleibt.

Jede Blende 35 besteht aus einem langgestreckten Streifen 35a, der die gesamte Länge der Fokallinie F abschirmen kann, und einem kurzen Streifen 35b, der nur den Infrarotfokus F_{IR} abschirmt, das sichtbare Licht jedoch durchläßt. Dabei kann wahlweise entweder der Bereich 35a oder der Bereich 35b auf die Fokallinie F eingestellt werden, oder die Blende 35 wird so weit verschwenkt, daß sie die Fokallinie F vollständig freigibt.

## Patentansprüche

1. Außenwandelement für Gebäude, mit einer Scheibe (10)
die mindestens ein strahlungssammelndes holografisches Element (14) aufweist, wobei im Abstand hinter jedem holografischen Element (14) im wesentlichen in dessen Fokalebene ein Strahlungsempfangselement (15) angeordnet ist, dessen Fläche kleiner ist als diejenige des holografischen Elementes (14), **dadurch gekennzeichnet,** daß die Scheibe (10) und das Strahlungsempfangselement (15) relativ zueinander derart bewegbar sind, daß die einfallende Strahlung wahlweise auf das Strahlungsempfangselement (15) gebündelt oder ganz oder teilweise an diesem vorbeigeleitet wird.

2. Außenwandelement nach Anspruch 1, dadurch gekennzeichnet, daß die Scheibe (10) zahlreiche holografische Elemente (14) aufweist, daß hinter der Scheibe (10) eine Tragstruktur (21) mit zahlreichen Strahlungsempfangselementen (15) angeordnet ist und daß die Scheibe (10) und die Tragstruktur (21) relativ zueinander unter Beibehaltung ihres Abstandes parallel verschiebbar sind.

3. Außenwandelement nach Anspruch 2, dadurch gekennzeichnet, daß die Scheibe (10) und die Tragstruktur (21) im wesentlichen vertikal angeordnet und relativ zueinander horizontal verschiebbar sind.

4. Außenwandelement nach einem der Ansprüche 1 bis 3, dadurch gekennzeichnet, daß die Scheibe (10) zusammen mit dem Strahlungsempfangselement (15) zur Anpassung an die Sonnenhöhe um eine im wesentlichen horizontale Achse (27) schwenkbar ist.

5. Außenwandelement nach einem der Ansprüche 1 bis 4, dadurch gekennzeichnet, daß die Scheibe (10) und das Strahlungsempfangselement (15) zur Anpassung an die Sonnenhöhe relativ zueinander in vertikaler Richtung derart bewegbar sind, daß die einfallende Strahlung stets auf denselben horizontalen Bereich des Strahlungsempfangselementes fokussiert wird.

6. Außenwandelement nach einem der Ansprüche 1 bis 5, dadurch gekennzeichnet, daß neben den Strahlungsempfangselementen reflektierende Bereiche (17) angeordnet sind, auf die mindestens ein Teil der einfallenden Strahlung konzentriert werden kann.

7. Außenwandelement nach einem der Ansprüche 1 bis 6, dadurch gekennzeichnet, daß das Strahlungsempfangselement derart ausgebildet oder angeordnet ist, daß es nur einen Teil des von dem holografischen Element zerlegten Spektrums empfängt.

8. Außenwandelement nach Anspruch 7, dadurch gekennzeichnet, daß der von dem Strahlungsempfangselement durchgelassene Teil des Spektrums durch vertikale Relativverschiebung zwischen Scheibe und Strahlungsempfangselement veränderbar ist, derart daß die Farbe des durchgelassenen Lichts verändert werden kann.

9. Außenwandelement nach einem der Ansprüche 1 bis 8, dadurch gekennzeichnet, daß die Scheibe und das Strahlungsempfangselement relativ zueinander horizontal verschiebbar sind, um den Anteil der von dem Strahlungsempfangselement empfangenen Strahlung zu verändern und eine Dimmwirkung zu erreichen.

10. Außenwandelement nach einem der Ansprüche 1 bis 9, dadurch gekennzeichnet, daß die Strahlungsempfangselemente (15) fotoelektrische Umsetzer oder Lichtwellenleiter sind.

11. Außenwandelement nach einem der Ansprüche 1 bis 10, dadurch gekennzeichnet, daß die Scheibe (10) und das Strahlungsempfangselement (15) zur Anpassung an die Sonnenbewegung in horizontaler Richtung relativ zueinander derart bewegt sind, daß die einfallende Strahlung stets auf dieselben vertikalen Linien der Strahlungsempfangselemente (15) fokussiert wird.

12. Außenwandelement nach einem der Ansprüche 1 bis 11, dadurch gekennzeichnet, daß das Strahlungsempfangselement (15) im vertikalen Querschnitt unter einem spitzen Winkel zu der Scheibe (10) verläuft, der dem Verlauf der spektralen Fokallinie (F) des Hologramms im wesentlichen entspricht.

## Claims

1. An external wall element for buildings, comprising a pane (10) being provided with at least one radiation-focussing holographic element (14), a radiation receiving element (15) being arranged in a distance behind each holographic element (14) and substantially in the focal plane thereof, the surface of the radiation receiving element being smaller than that of the holographic element (14), characterised in that the pane (10) and the radiation receiving element (15) are movable relative to one another such that the incident radiation is alternatively focussed onto the radiation receiving element (15) or entirely or partially conducted past the radiation receiving element.

2. The external wall element according to claim 1, characterised in that the pane (10) has a plurality of holographic elements (14), that a supporting structure (21) having numerous radiation receiving elements (15) is arranged behind the pane (10), and that the pane (10) and the supporting structure (21) are displaceable in parallel relative to one another, while maintaining their mutual distance.

3. The external wall element according to claim 2, characterised in that the pane (10) and the supporting structure (21) are arranged substantially vertical and are horizontally displaceable relative to each other.

4. The external wall element according to one of claims 1 to 3, characterised in that the pane (10) is pivotable around a substantially horizontal axis (27) together with the radiation receiving element (15) in order to be adjusted to the position of the sun.

5. The external wall element according to one of claims 1 to 4, characterised in that, for an adjustment to the position of the sun, the pane (10) and the radiation receiving element (15) are movable relative to each other in the vertical direction such that the incident radiation is always focussed on the same horizontal region of the radiation receiving element.

6. The external wall element according to one of claims 1 to 5, characterised in that reflecting regions (17) are arranged beside the radiation receiving elements, on which at least a part of the incident radiation may be concentrated.

7. The external wall element according to one of claims 1 to 6, characterised in that the radiation receiving element is configured or arranged such that it receives only a part of the spectrum decomposed by the holographic element.

8. The external wall element according to claim 7, characterised in that the part of the spectrum transmitted by the radiation receiving element may be changed by a vertical relative displacement between the pane and the radiation receiving element such that the color of the transmitted light may be changed.

9. The external wall element according to one of claims 1 to 8, characterised in that the pane and the radiation receiving element are horizontally displaceable relative to each other to change the ratio of the radiation received by the radiation receiving element and to obtain a dimming effect.

10. The external wall element according to one of claims 1 to 9, characterised in that the radiation receiving elements (15) are photoelectric transducers or light wave conductors.

11. The external wall element according to one of claims 1 to 10, characterised in that, for adjustment to the movement of the sun, the pane (10) and the radiation receiving element (15) are movable relative to each other in the horizontal direction such that the incident radiation is always focussed on the same vertical lines of the radiation receiving elements (15).

12. The external wall element according to one of claims 1 to 11, characterised in that - seen in vertical section - the radiation receiving element (15) extends in an acute angle with respect to the pane (10), which angle substantially corresponds to the course of the spectral focal line (F) of the hologram.

## Revendications

1. Elément de paroi extérieure pour édifices, avec un vitrage (10) qui comporte au moins un élément holographique (14) collecteur de rayonnement, un élément récepteur de rayonnement (15), dont la surface est plus petite que celle de l'élément holographique (14), étant disposé à distance derrière chaque élément holographique (14), sensiblement dans son plan focal, caractérisé par le fait que le vitrage (10) et l'élément récepteur de rayonnement (15) peuvent se déplacer l'un par rapport à l'autre de telle manière que le rayonnement incident est au choix dirigé en faisceau sur l'élément récepteur de rayonnement (15) ou est, en tout ou en partie, guidé à côté de celui-ci.

2. Elément de paroi extérieure selon la revendication 1, caractérisé par le fait que le vitrage (10) présente de nombreux éléments holographiques (14), que derrière le vitrage (10) est disposée une structure porteuse (21) avec de nombreux éléments récepteurs de rayonnement (15) et que le vitrage (10) et la structure porteuse (21) peuvent être déplacés parallèlement l'un par rapport à l'autre, tout en conservant leur distance.

3. Elément de paroi extérieure selon la revendication 2, caractérisé par le fait que le vitrage (10) et la structure porteuse (21) sont disposés sensiblement verticalment et peuvent être déplacés horizontalement l'un par rapport à l'autre.

4. Elément de paroi extérieure selon l'une des revendications 1 à 3, caractérisé par le fait que le vitrage (10) est, en même temps que l'élément récepteur de rayonnement (15), susceptible de pivoter autour d'un axe sensiblement horizontal (27), en vue de l'adaptation à la hauteur du soleil.

5. Elément de paroi extérieure selon l'une des revendications 1 à 4, caractérisé par le fait qu'en vue de l'adaptation à la hauteur du soleil, le vitrage (10) et l'élément récepteur de rayonnement (15) peuvent être déplacés dans le sens vertical l'un par rapport à l'autre de telle manière que le rayonnement incident soit toujours concentré sur la même zone horizontale de l'élément récepteur de rayonnement.

6. Elément de paroi extérieure selon l'une des revendications 1 à 5, caractérisé par le fait qu'à côté des éléments récepteurs de rayonnement, sont disposées des zones réfléchissantes (17) sur lesquelles peut être concentrée au moins une partie du rayonnement incident.

7. Elément de paroi extérieure selon l'une des revendications 1 à 6, caractérisé par le fait que l'élément récepteur de rayonnement est constitué ou est disposé de telle manière qu'il ne reçoit qu'une partie due spectre décomposé par l'élément holographique.

8. Elément de paroi extérieure selon la revendication 7, caractérisé par le fait que la partie du spectre que laisse passer l'élément récepteur de rayonnement peut être modifiée par un déplacement vertical relatif du vitrage et de l'élément récepteur de rayonnement de telle sorte que la couleur de la lumière, qui passe, peut être changée.

9. Elément de paroi extérieure selon l'une des revendications 1 à 8, caractérisé par le fait que le vitrage et l'élément récepteur de rayonnement peuvent être déplacés horizontalement l'un par rapport à l'autre pour changer la part du rayonnement reçu par l'élément récepteur de rayonnement et obtenir un effet d'atténuation.

10. Elément de paroi extérieure selon l'une des revendications 1 à 9, caractérisé par le fait que les éléments récepteurs de rayonnement (15) sont des transformateurs photo-électriques ou des guides d'ondes optiques.

11. Elément de paroi extérieure selon l'une des revendications 1 à 10, caractérisé par le fait qu'en vue de l'adaptation au mouvement du soleil, le vitrage (10) et l'élément récepteur de rayonnement (15) sont déplacés l'un par rapport à l'autre dans le sens horizontal de telle manière que le rayonnement incident soit toujours concentré sur les mêmes lignes verticals de l'élément récepteur de rayonnement (15).

12. Elément de paroi extérieure selon l'une des revendications 1 à 11, caractérisé par le fait que l'élément récepteur de rayonnement (15) s'étend, en section vertical, en formant par rapport au vitrage (10) un angle aigu, qui correspond sensiblement au tracé de la ligne focale spectrale (F) de l'hologramme.
